# EUROPÄISCHE PATENTSCHRIFT

(11) **EP 3 709 513 B1**
(45) Veröffentlichungstag und Bekanntmachung des Hinweises auf die Patenterteilung: **06.12.2023**
(21) Anmeldenummer: 20158597.3
(22) Anmeldetag: 20.02.2020
(51) Int. Cl.: H03K 17/0814, H03K 17/12, G01R 31/26, G01R 31/27

(54) **SCHALTVORRICHTUNG SOWIE VERFAHREN ZUM BETRIEB EINER SCHALTVORRICHTUNG**
SWITCHING DEVICE AND METHOD FOR OPERATING SAME
DISPOSITIF DE COMMUTATION AINSI QUE PROCÉDÉ DE FONCTIONNEMENT D'UN DISPOSITIF DE COMMUTATION

(30) Priorität: 15.03.2019 DE 102019203508
(43) Veröffentlichungstag der Anmeldung: 16.09.2020
(73) Patentinhaber: LEONI Bordnetz-Systeme GmbH, 97318 Kitzingen (DE)
(72) Erfinder: DELLIT, Marcus, 97218 Gerbrunn (DE); KIRSCH, Christoph, 97084 Würzburg (DE); SCHRAUD, Bernhard, 97084 Würzburg (DE); NEUBERT, Joachim, 97084 Würzburg (DE)
(74) Vertreter: FDST Patentanwälte

(56) Entgegenhaltungen:
- DE-A1- 10 046 668
- DE-A1-102006 040 737
- US-A1- 2009 109 586
- US-A1- 2016 352 318

## Beschreibung

Die Erfindung betrifft eine Schaltvorrichtung sowie ein Verfahren zum Betrieb einer Schaltvorrichtung zum elektrischen Verbinden einer elektrischen Last mit einer Energiequelle.

Bei elektrischen Versorgungsnetzen, insbesondere bei Kraftfahrzeugbordnetzen, sind üblicherweise die vorhandenen elektrischen Verbraucher über Schaltvorrichtungen mit einer Energiequelle elektrisch verbunden. Als Energiequelle dient hierbei beispielsweise eine Batterie des Kraftfahrzeuges.

Die Schaltvorrichtungen weisen üblicherweise elektronische Leistungsschalter auf, die als Trennelement zwischen den Verbrauchern und der Energiequelle angeordnet sind. Bei den hier interessierenden Verbrauchern handelt es sich insbesondere um Hochstrom-Verbraucher, wie beispielsweise Elektromotoren, die im Betrieb einen Stromverbrauch von >10A oder >50A und insbesondere >100 A aufweisen.

Um die Funktion der Leistungsschalter sicherzustellen, müssen diese üblicherweise auf ihre Funktionsfähigkeit hin überprüft werden. Gleichzeitig soll hierbei jedoch eine elektrische Energieversorgung des jeweiligen Verbrauchers, der über den zu prüfenden Leistungsschalter mit der Energiequelle verbunden ist, nicht unterbrochen sein.

Auch sollen die Leistungsschalter bei einem Abschalten, also Öffnen, vor negativen Spannungsimpulsen, die beim Abschalten von insbesondere induktiven Lasten entstehen, geschützt sein.

Aus der US 2016/0352318 A1 ist eine Schaltvorrichtung zu entnehmen, bei der zum Schutz eines Schalters beim Abschalten einer induktiven Last zwei zum Schalter parallele Strompfade vorgesehen sind. In dem ersten parallelen Strompfad ist eine steuerbarer Halbleiterschalter angeordnet. Dessen Gate-Anschluss ist mit dem zweiten parallelen Strompfad verbunden. In diesem ist eine Zenerdiode angeordnet. Beim Auftreten einer Spannungsspitze, die die DurchbruchSpannung der Zenerdiode übersteigt, liegt eine Spannung an den Gate-Anschluss des Halbleiterschalters an, sodass der erste Strompfad geöffnet ist und die Spannungsspitzen über diesen abgeleitet wird.

Aus der US 2009/0109586 A1 ist eine schalt Anordnung zu entnehmen, mit der eine über einen Halbleiterschalter schaltbare Last bei einem Einschalten überprüft wird. Zur Überprüfung der Last wird ein Einschalt-Signal für den Halbleiterschalter verzögert und während dieser Verzögerungszeit wird an die Last eine Diagnosespannung angelegt und eine Diagnose durchgeführt. Wird dabei ein Schaden der Last festgestellt, erfolgt eine Notabschaltung und zwar bereits frühzeitig während der Verzögerungszeit, bevor das eigentliche Zuschalten der Last über den Halbleiterschalter erfolgt.

Aus der DE 10 2006 040 737 A1 ist eine Vorrichtung zur Erkennung eines Nebenschlusses an einer Ventilendstufe zu entnehmen, bei der bei ausgeschalteter Stromversorgung für eine Spule des Ventils ein Testpfad geschlossen wird und ein Spannungsabfall im Hinblick auf einen bestehenden Nebenschluss ausgewertet wird.

Ausgehend hiervon liegt der Erfindung die Aufgabe zugrunde, eine Schaltvorrichtung sowie ein Verfahren zum Betrieb einer Schaltvorrichtung anzugeben, mit deren Hilfe ein elektrischer Verbraucher zuverlässig mit der elektrischen Energiequelle verbunden ist.

Die auf die Schaltvorrichtung gerichtete Aufgabe wird erfindungsgemäß gelöst durch eine Schaltvorrichtung mit den Merkmalen des Anspruchs 1.

Vorteilhafte Ausgestaltungen, Weiterbildungen und Varianten sind Gegenstand der Unteransprüche.

Die Schaltvorrichtung ist insbesondere als eine Schaltvorrichtung für ein Kraftfahrzeugbordnetz ausgebildet und dient zu einem elektrischen Verbinden einer elektrischen Last mit einer Energiequelle. Unter der elektrischen Last wird hierbei beispielsweise jegliche Art von elektrischen Verbrauchern innerhalb des Kraftfahrzeuges und vorzugsweise induktive Lasten verstanden. Der Begriff Last umfasst hierbei ein oder auch mehrere Verbraucher. Speziell handelt es sich bei der Last um eine Hochstrom-Last, wie eingangs definiert. Unter der Energiequelle wird hierbei vorzugsweise eine Kraftfahrzeugbatterie oder ein Spannungswandler, der innerhalb des Kraftfahrzeuges angeordnet ist, verstanden.

Die Schaltvorrichtung weist einen Hauptstrompfad auf, der eine Schalteinheit mit zumindest einem Leistungsschalter aufweist. Der Hauptstrompfad und die Schalteinheit sind zur Versorgung der daran angeschlossenen Last (ein oder mehrere Verbraucher) mit einem (maximalen) Gesamt-Betriebsstrom ausgelegt. Dieser Gesamt-Betriebsstrom liegt insbesondere >10A oder >50A und insbesondere >100 A beispielsweise bis hin zu 1000A, insbesondere bei kurzzeitigen Belastungen. Unter Leistungsschalter wird vorliegend allgemein ein Schalter zum Schalten einer elektrischen Leistung verstanden, insbesondere zum Schalten von elektrischen Strömen mit einer Stromstärke von zumindest 1A vorzugsweise von zumindest 5A oder auch von zumindest 10A. In der Schalteinheit sind üblicherweise mehrere Leistungsschalter parallel zueinander angeordnet. Der bzw. die Leistungsschalter ist/sind bevorzugt als Halbleiterschalter und insbesondere als Leistungs-MOSFET ausgebildet. Über diesen ist die elektrische Last in einem Versorgungs-Modus mit der Energiequelle verbunden. Unter dem Versorgungs-Modus wird ein (Betriebs-)Modus der Schaltvorrichtung verstanden, der einem Betriebszustand entspricht, in dem der zumindest eine Leistungsschalter geschlossen ist und die elektrische Last vorzugsweise durchgängig, also kontinuierlich mit der Energiequelle verbindet, sodass die elektrische Last mit elektrischer Energie versorgt ist.

Weiterhin weist die Schaltvorrichtung einen parallel zu dem Hauptstrompfad verschalteten Nebenstrompfad auf, in dem ein erstes Schaltelement angeordnet ist.

Es ist ein Abschalt-Modus vorgesehen, in dem die Versorgung der Last über den Hauptstrompfad unterbrochen wird, die Last also abgeschalten wird. Dies erfolgt durch ein Öffnen der Schalteinheit, also der darin angeordneten Leistungsschalter. Unter dem Abschalten wird hierbei verstanden, dass die Leistungsschalter von einem leitenden Zustand in einen sperrenden Zustand geschaltet werden, also geöffnet werden. Allgemein wird im Abschalt-Modus die Last nicht mit elektrischer Energie aus der Energiequelle versorgt.

In der zumindest einen über die Schalteinheit angeschlossenen Last sowie ggf. innerhalb der Leitungen ist eine hohe Energie, insbesondere induktive Energie gespeichert, die abgebaut werden muss. Hierzu ist allgemein ein parallel zum Hauptstrompfad geschalteter Bypass- oder Freilaufpfad ausgebildet, mit dem die Last im Abschalt-Modus verbunden ist und über den die gespeicherte elektrische Energie reduziert und abgebaut wird. Hierzu wird allgemein der Freilaufpfad über ein Schaltelement zugeschalten. Im Freilaufpfad ist zumindest ein geeigneter Verbraucher, wie beispielsweise ein oder mehrere Leistungswiderstände zur Reduzierung der gespeicherten Energie angeordnet.

Der Freilaufpfad ist dabei durch den Nebenstrompfad gebildet. Im Abschalt-Modus ist das im Nebenstrompfad angeordnete erste Schaltelement also geschlossen. Die elektrische Last ist im Abschalt-Modus insofern lediglich über den Nebenstrompfad mit der Energiequelle verbunden.

Ein Abschalten und somit ein Öffnen der Schalteinheit erfolgt bei einem Abschaltbefehl und insbesondere dann, wenn die elektrische Last einen Fehler aufweist, um die fehlerhafte elektrische Last von dem Kraftfahrzeugbordnetz zu trennen. Ein Abschalten erfolgt beispielsweise auch dann, wenn die entsprechende Anforderung durch ein übergeordnetes Steuergerät erfolgt, welches also einen Abschaltbefehl abgibt.

Insbesondere bei einer als eine induktive Last ausgebildeten elektrischen Last tritt bei einem Abschalten und somit Trennen der elektrischen Verbindung zwischen der elektrischen Last und der Energiequelle ein negativer Spannungsimpuls (auch als negative Spannungsspitze bezeichnet) auf. Dieser negative Spannungsimpuls resultiert nach dem Induktionsgesetz aus einem Absinken des durch die elektrische Last im Versorgungs-Modus fließenden Laststromes und der gespeicherten induktiven Energie innerhalb der elektrischen Last. Dieser negative Spannungsimpuls kann - bei fehlendem Freilaufpfad - dazu führen, dass der geöffnete zumindest eine Leistungsschalter erneut in einen leitenden Zustand übergeht, sich also ungewollt schließt. Die innerhalb der elektrischen Last gespeicherte induktive Energie (auch als induktive Abschaltenergie bezeichnet) entlädt sich dann nach dem ungewollten Schließen innerhalb des zumindest einen Leistungsschalters, was zu einer Überlastung dessen und somit zu einem Ausfalls des Leistungsschalters und folglich der Schaltvorrichtung führen kann.

Da im Abschalt-Modus die elektrische Last lediglich über den Nebenstrompfad mit der Energiequelle verbunden ist, wird erreicht, dass die induktive Energie der elektrischen Last über den Nebenstrompfad abfließt und verbraucht wird. Hierzu ist im Nebenstrompfad der bereits erwähnte Leistungsverbraucher angeordnet. Dieser weist insbesondere mehrere in Serie geschaltete Leistungswiderstände auf. Somit wird der zumindest eine Leistungsschalter im Abschalt-Modus geschützt. Der Nebenstrompfad wird hierdurch auch als Bypass-Pfad bezeichnet.

Weiterhin ist ein Diagnose-Modus vorgesehen, in dem die Schalteinheit ebenfalls geöffnet ist, die Versorgung der Last über den Hauptstrompfad also unterbunden ist. Die elektrische Last ist lediglich über den Nebenstrompfad mit der Energiequelle verbunden und wird über den Nebenstrompfad mit Energie aus der Energiequelle versorgt. Innerhalb des Diagnose-Modus dient die elektrische Verbindung der elektrischen Last mit der Energiequelle durch den Nebenstrompfad - anders als im Abschalt-Modus - also einer Versorgung der elektrischen Last. Hierdurch ist erreicht, dass trotz der geöffneten Schalteinheit im Diagnose-Modus eine Versorgung der elektrischen Last mit elektrischer Energie nicht unterbrochen ist. Somit ist erreicht, die Versorgung der elektrischen Last zusätzlich zu der Versorgung über den Hauptstrompfad auch über den Nebenstrompfad zu realisieren und eine unterbrechungsfreie elektrische Versorgung der elektrischen Last auch bei geöffneter Schalteinheit im Hauptstrompfad Leistungsschalter sicherzustellen.

Im Diagnose-Modus erfolgt weiterhin eine Diagnose der Schaltvorrichtung und ggf. der daran angeschlossenen Last. Insbesondere erfolgt eine Überprüfung des bzw. der Leistungsschalter der Schalteinheit auf ihre Funktionsfähigkeit hin.

Weiterhin ist eine Steuereinheit vorgesehen, die dazu dient, die einzelnen unterschiedlichen Modi und insbesondere den Diagnose-Modus zu aktivieren, speziell durch ein Ansteuern der verschiedenen Schaltelemente, also beispielsweise durch ein Ansteuern der Schalteinheit im Hauptstrompfad und dem ersten Schaltelement im Nebenstrompfad. Die Steuereinheit ist bevorzugt als ein Mikrocontroller ausgebildet.

Durch die Schaltvorrichtung sowie die unterschiedlichen Modi (Versorgungs-Modus, Abschalt-Modus sowie Diagnose-Modus) ist eine Schaltvorrichtung realisiert, die zum einen derart ausgebildet ist, beim Abschalten innerhalb der elektrischen Last, gespeicherte induktive Energie zu reduzieren und zum anderen eine unterbrechungsfreie elektrische Versorgung der elektrischen Last sicherzustellen, insbesondere dann, wenn sich der zumindest eine Leistungsschalter im Diagnose-Modus zur Überprüfung seiner Funktionsfähigkeit im geöffneten, also sperrenden Zustand befindet.

Der Nebenstrompfad und insbesondere das darin angeordnete erste Schaltelement zum Öffnen und Schließen des Nebenstrompfades sind dabei vorzugsweise nur für einen Teil (beispielsweise max. 50%, max. 25% und weiter vorzugsweise zumindest für 5% oder 10%) des (maximalen) Gesamt-Betriebsstroms ausgelegt, wohingegen der Hauptstrompfad und die darin angeordnete Schalteinheit für den (maximalen) Gesamt-Betriebsstroms ausgelegt ist.

Gemäß einer bevorzugten Ausgestaltung ist das erste Schaltelement derart ausgebildet, dass es automatisch geschlossen wird und die Last mit dem Leistungsverbraucher zur Reduzierung der gespeicherten elektrischen Energie verbindet, wenn die Last abgeschaltet wird. Ein aktives Ansteuern ist daher nicht erforderlich. Die Freigabe des Bypass- oder Freilaufpfades erfolgt also unabhängig von einem Steuerbefehl allein aufgrund der bei einem Abschalten auftretenden Spannungsimpulse.

Insbesondere ist das Schaltelement hierzu als ein Halbleiterschalter, insbesondere als ein MOSFET und speziell als ein Leistungs-MOSFET ausgebildet. Das erste Schaltelement weist somit einen Gate Anschluss mit einem Gate-Spannungspotential auf. Weiterhin weist das erste Schaltelement einen Source-Anschluss auf, an dem die elektrische Last angeschlossen ist. Ein Drain-Anschluss des ersten Schaltelements ist hierbei bevorzugt mit der Energiequelle verbunden. Bevorzugt ist das Gate-Spannungspotential über einen Masse-Anschluss mit einem Massepotential elektrisch verbunden.

Dieser bevorzugten Ausgestaltung liegt der Gedanke zugrunde, dass durch das elektrische Verbinden des Gate-Spannungspotentials mit dem Massepotential bei Vorliegen des negativen Spannungsimpulses beim Abschalten des zumindest einen Leistungsschalters ein automatisches Verbinden der elektrischen Last über den Nebenstrompfad mit der Energiequelle erfolgt. Mit anderen Worten ist ein Schließen des ersten Schaltelements des Nebenstrompfads dadurch erreicht, dass durch den negativen Spannungsimpuls eine Spannungsdifferenz zwischen dem Gate-Spannungspotential und dem Source-Spannungspotential erreicht ist, die betragsmäßig zumindest den gleichen Wert und bevorzugt einen größeren Wert aufweist, als eine (vorgegebene und festgelegte) Steuerspannung, die zwischen dem Gate-Anschluss und dem Source-Anschluss anliegen muss, damit das erste Schaltelement von einem sperrenden (hochohmigen) Zustand in einen leitenden (niederohmigen) Zustand übergeht. Somit ist ein automatisches Schließen des ersten Schaltelements im Abschalt-Modus aufgrund des Abschaltverhaltens der induktiven Last erreicht. Es ist folglich insbesondere kein aktives und/oder externes Schaltsignal erforderlich. Der Vorteil dieser Ausgestaltung ist zum einen in einer Vereinfachung des Schaltaufwandes und zum anderen in einer nicht erforderlichen Notwendigkeit einer aktiven Überwachung zu sehen.

Bevorzugt weist der Nebenstrompfad eine Diode auf, die zwischen dem Gate Anschluss des ersten Schaltelements und dem Massepotential angeordnet ist. Die Diode ist vorzugsweise in Sperrrichtung mit dem Massepotential elektrisch verbunden.

Zweckdienlicherweise ist in dem Nebenstrompfad als Leistungsverbraucher ein Widerstandselement angeordnet. Bei dem Widerstandselement handelt es sich bevorzugt um einen ohmschen Widerstand und speziell um einen Leistungswiderstand. Das Widerstandselement dient zur Umwandlung der innerhalb der elektrischen Last gespeicherten elektrischen und vorzugsweise induktiven Energie im Abschalt-Modus. Die elektrische Energie wird durch das Widerstandselement im Abschalt-Modus in thermische Energie umgewandelt. Durch die Anordnung des Widerstandselements ist eine einfache und zuverlässige Umwandlung und somit ein Abbau der elektrischen Energie der elektrischen Last im Abschalt-Modus erreicht. Weiterhin weisen - durch die spezielle Ausgestaltung des Widerstandselements als ein Leistungswiderstand und die spezielle Ausgestaltung des ersten Schaltelements als ein Leistungs-MOSFET - diese Bauteile eine hohe Temperaturbeständigkeit auf.

Allgemein ist die gesamte Schaltvorrichtung (speziell Widerstandselement und erstes Schaltelement sowie die Schalteinheit) - neben der Eignung zum Schalten von hohen Strömen und Energien - auch für eine hohe Temperaturbeanspruchung ausgelegt, derart dass ihre Funktionsfähigkeit in einem Temperaturbereich von vorzugsweise 100°C bis 150°C nicht beeinträchtigt ist. Die Schaltvorrichtung eignet sich daher auch zur Anordnung in thermisch hoch beanspruchten Bereichen. Beispielsweise wird sie im Bereich eines Antriebsmotors eines Fahrzeugs eingesetzt.

Gemäß einer bevorzugten Ausgestaltung weist das Gate-Spannungspotential des ersten Schaltelements im Diagnose-Modus den gleichen Wert auf, wie ein Spannungspotential der Energiequelle. Unter dem gleichen Wert wird hierbei verstanden, dass der Wert des Gate-Spannungspotentials im Wesentlichen einem Wert des Spannungspotentials der Energiequelle entspricht. Unter im Wesentlichen wird hierbei verstanden, dass das Gate-Spannungspotential einen Wert aufweist, der bis auf mögliche Toleranzen aufgrund von Spannungsabfällen, die bei den Schaltvorgängen auftreten, den gleichen Wert aufweist wie das Spannungspotential der Energiequelle. Unter dem Spannungspotential der Energiequelle wird beispielsweise eine Betriebsspannung der innerhalb des Kraftfahrzeuges angeordneten Batterie oder eine Ausgangsspannung des bereits erwähnten Spannungswandlers verstanden.

Vorzugsweise ist ein zweites Schaltelement vorgesehen, zum elektrischen Verbinden des Gate-Anschlusses des ersten Schaltelements mit der Energiequelle im Diagnose-Modus. Hierdurch wird daher das Spannungspotential der Energiequelle am Gate-Anschluss des ersten Schaltelements angelegt. Das elektrische Verbinden des Gate-Anschlusses erfolgt hierbei vorzugsweise an einen Phasenanschluss, also an einen "Plus-Pol" der Energiequelle. Durch das zweite Schaltelement ist ein reversibles und schaltbares elektrisches Verbinden des Gate-Anschlusses mit der Energiequelle im Diagnose-Modus realisiert.

Bei der zuvor erwähnten Aktivierung des Diagnose-Modus durch die Steuereinheit erfolgt somit ein elektrisches Verbinden des Gate-Anschlusses mit der Energiequelle durch Schließen des zweiten Schaltelements.

Gemäß einer zweckdienlichen Weiterbildung ist die Steuereinheit derart eingerichtet, eine elektrische Ausgangsspannung, die an der elektrischen Last anliegt, zu erfassen. Hierzu weist die Steuereinheit entweder eine Spannungserfassungseinheit auf oder ist mit einer derartigen Spanungserfassungseinheit verbunden. Unter der elektrischen Ausgangsspannung wird hierbei die Spannung verstanden, mit der die elektrische Last versorgt ist.

Dieser Weiterbildung liegt der Gedanke zugrunde, dass bei einer elektrischen Versorgung der Last über den Nebenstrompfad im Diagnose-Modus die Ausgangsspannung, die an elektrischen Last anliegt, einen um vorzugsweise 2V bis 4V geringeren Wert aufweist als die Ausgangsspannung, wenn die elektrische Last über den Hauptstrompfad mit der Energiequelle elektrisch verbunden ist. Dieser Spannungsunterschied der Ausgangsspannung beruht darauf, dass beim Schließen des ersten Schaltelements durch das elektrische Verbinden des Gate-Anschlusses des ersten Schaltelements mit der Energiequelle und somit dem Anschluss des Gate-Spannungspotential mit dem Spannungspotential der Energiequelle im Diagnose-Modus ein Teil der Versorgungsspannung der Energiequelle über dem ersten Schaltelement abfällt und somit die Ausgangsspannung, die im Diagnose-Modus an der elektrischen Last anliegt verringert. Unter dem Teil der Versorgungsspannung werden hierbei die bereits erwähnten 2V bis 4V verstanden.

Insgesamt ist daher anhand der Ausgangsspannung erkennbar, ob der Hauptstrompfad getrennt und der Nebenstrompfad geschlossen ist. Durch die Erfassung der an der elektrischen Last anliegenden Ausgangsspannung seitens der Steuereinheit ist also eine Unterscheidung zwischen den Schaltungs-Zuständen des Versorgungs-Modus und des Diagnose-Modus ermöglicht. Speziell kann hierdurch in einfacher Weise zuverlässig festgestellt werden, ob die Voraussetzungen für die durchzuführende Diagnose vorliegen. Entsprechend ist in bevorzugter Weiterbildung in Abhängigkeit der erfassten Ausgangsspannung ein Starten der Diagnose vorgesehen, also insbesondere ein Starten der Überprüfung der Leistungsschalter der Schalteinheit.

Bevorzugt ist die Steuereinheit derart eingerichtet, im Diagnose-Modus den zumindest einen Leistungsschalter zu überprüfen. Hierbei ist die Steuereinheit derart eingerichtet, den zumindest einen Leistungsschalter insbesondere im Hinblick auf seine Funktionsfähigkeit hin zu überprüfen. Diese Überprüfung findet dabei statt, ohne dass eine Versorgung der Last unterbrochen ist. Die Überprüfung findet insbesondere in einem verbrauchsarmen Zustand statt, wenn also lediglich ein Teil der Gesamt-Betriebslast von der angeschlossenen Last benötigt wird.

Bevorzugt ist die Steuereinheit mit einem Strommesselement verbunden. Alternativ weist die Steuereinheit ein Strommesselement auf. Das Strommesselement ist dabei derart eingerichtet, einen Laststrom zu erfassen, der durch die elektrische Last fließt. Weiterhin ist die Steuereinheit derart eingerichtet, in Abhängigkeit eines Wertes des erfassten Laststromes durch eine Ansteuerung des ersten Schaltelements und bevorzugt durch eine Ansteuerung des zumindest einen Leistungsschalters zwischen dem Versorgungs-Modus und dem Diagnose-Modus umzuschalten.

Dieser Ausgestaltung liegt der Gedanke zugrunde, einen Zeitpunkt der Diagnose und somit die Aktivierung des Diagnose-Modus des zumindest einen Leistungsschalters derart zu wählen, dass der Diagnose-Modus dann aktiviert wird, wenn ein Stromverbrauch der elektrischen Last und somit ein durch diese fließender elektrischer Laststrom gering ist. Unter dem geringen Stromverbrauch wird hierbei ein Stromverbrauch verstanden, der beispielsweise dann auftritt, wenn sich die elektrische Last in einem Ruhezustand (auch als Stand-by Zustand bezeichnet) oder allgemein in einem Zustand geringen Strombedarfs befindet. Unter dem Ruhezustand wird hierbei ein Zustand der elektrischen Last verstanden, in dem entweder keine oder vorzugsweise nur ein Teil aller Funktionen der elektrischen Last aktiv sind. Befindet sich die elektrische Last in einem derartigen Ruhezustand und wird dies durch eine Erfassung eines geringeren Laststromes seitens der Steuereinheit erkannt, schaltet diese von dem Versorgungs-Modus in den die Diagnose-Modus und führt somit eine Überprüfung des zumindest einen Leistungsschalters durch, während die elektrische Versorgung der elektrischen Last über den Nebenstrompfad sichergestellt ist. Allgemein wird bei Bedarf in den Diagnose-Modus umgeschaltet, wenn der Laststrom kleiner dem Strom ist, für den der Nebenstrompfad ausgelegt ist, also beispielsweise kleiner 50% oder kleiner 25% oder auch kleiner 10% des (maximalen) Gesamt-Betriebsstroms, für den die Schalteinheit im Hauptstrompfad ausgelegt ist. Der Diagnose-Modus wird vorzugsweise nur dann aktiviert, wenn die Last in einem derartigen Zustand geringen Strombedarfs ist.

Alternativ ist die Schalteinheit extern angesteuert, beispielsweise über eine Ansteuereinheit. In diesem Fall erhält die Ansteuereinheit von der Steuereinheit einen Schaltbefehl, um die Schalteinheit zu öffnen oder zu schließen, um so zwischen dem Versorgungs-Modus und dem Diagnose-Modus umzuschalten und umgekehrt.

Gemäß einer bevorzugten Ausgestaltung ist der Nebenstrompfad allgemein für einen geringeren Strom geringer als der Hauptstrompfad ausgelegt. Dies gilt beispielsweise für die in den beiden Strompfaden eingesetzten Schaltelemente und/oder auch hinsichtlich der (Gesamt-) Leitungsquerschnitte in den beiden Pfaden. Dieser Ausgestaltung liegt der Gedanke zugrunde, dass, wie bereits vorstehend erwähnt, der Nebenstrompfad vorzugsweise während des Diagnose-Modus zur elektrischen Versorgung der elektrischen Last, insbesondere im Ruhezustand dient. Hierdurch ist der Nebenstrompfad im Diagnose-Modus einer geringeren Strombelastung als der Hauptstrompfad ausgesetzt. Durch die Auslegung des Nebenstrompfades für geringere Ströme werden weiterhin Material-und Kosteneinsparungen erreicht.

Der wesentliche Vorteil der vorstehend beschriebenen Schaltvorrichtung ist in den beiden realisierbaren Funktionen der Schaltvorrichtung, nämlich zum einen ein Reduzieren der elektrischen Energie innerhalb der elektrischen Last beim Abschalten (Abschalt-Modus) und zum anderen durch die Sicherstellung der elektrischen Versorgung bei der Überprüfung des zumindest einen Leistungsschalters (Diagnose-Modus) zu sehen, wobei der Abschalt-Modus und der Diagnose-Modus im Wesentlichen beide durch den Nebenstrompfad verwirklicht sind. Maßgebend ist hierbei auch, dass das erste Schaltelement derart verschaltet und ansteuerbar ist, dass es zum einen für den Abschalt-Modus automatisch schaltet und für den Diagnose Modus aktiv in den geschlossenen Zustand überführt werden kann. Über den Nebenstrompfad und über das erste Schaltelement, in Kombination mit dem zweiten Schaltelement wird daher eine Doppelfunktion erreicht.

Die auf das Verfahren gerichtete Aufgabe wird erfindungsgemäß gelöst durch ein Verfahren zum Betrieb einer Schaltvorrichtung mit den Merkmalen des Anspruchs 13. Das Verfahren dient insbesondere einem elektrischen Verbinden einer elektrischen Last mit einer Energiequelle durch die Schaltvorrichtung.

Bei der Schaltvorrichtung handelt es sich insbesondere um die bereits vorstehend erwähnte Schaltvorrichtung.

Somit wird bei dem Verfahren über einen Hauptstrompfad, der zumindest einen Leistungsschalter aufweist, die elektrische Last in einem Versorgungs-Modus mit der Energiequelle verbunden, indem der zumindest eine Leistungsschalter geschlossen wird.

In einem Abschalt-Modus wird der zumindest eine Leistungsschalter geöffnet und die elektrische Last lediglich über einen Nebenstrompfad, der ein erstes Schaltelement aufweist, mit der Energiequelle verbunden, indem das erste Schaltelement geschlossen wird. Hierbei wird eine innerhalb der elektrischen Last gespeicherte elektrische Energie über den Nebenstrompfad reduziert. Bevorzugt ist hierbei innerhalb des Nebenstrompfads ein Widerstandselement zur Umwandlung der elektrischen Energie in thermische Energie angeordnet.

In einem Diagnose-Modus wird der zumindest eine Leistungsschalter geöffnet und das erste Schaltelement geschlossen. Hierbei wird die elektrische Last lediglich über den Nebenstrompfad mit der Energiequelle verbunden, wobei im Diagnose-Modus der zumindest eine Leistungsschalter überprüft wird und gleichzeitig eine elektrische Energieversorgung der elektrischen Last über den Nebenstrompfad sichergestellt wird.

Bevorzugt ist das erste Schaltelement als ein Halbleiterschalter ausgebildet, der im Abschalt-Modus durch ein von der Last nach einem Abschalten herrührenden negativen Spannungsimpuls automatisch geschlossen wird.

Weiterhin wird bevorzugt im Diagnose-Modus das erste Schaltelement durch ein zweites Schaltelement aktiv geschlossen.

Die im Hinblick auf die Schaltvorrichtung aufgeführten Vorteile und bevorzugten Ausgestaltungen sind sinngemäß auf das Verfahren zu übertragen und umgekehrt.

Ein Ausführungsbeispiel der Erfindung wird nachfolgend anhand der Figuren näher erläutert. Diese zeigen teilweise in stark vereinfachter Darstellung:
- FIG 1: ein grob schematisiertes Schaltbild der Schaltvorrichtung,
- FIG 2: beispielhaft den Verlauf einer Ausgangsspannung der Schaltvorrichtung und eines Laststroms beim Ab- und wieder zuschalten einer Last,
- FIG 3: beispielhaft den Verlauf der Ausgangsspannung der Schaltvorrichtung in Abhängigkeit von Ansteuersignalen für Schaltelemente.

Einander entsprechende Teile sind in allen Figuren jeweils mit den gleichen Bezugszeichen versehen.

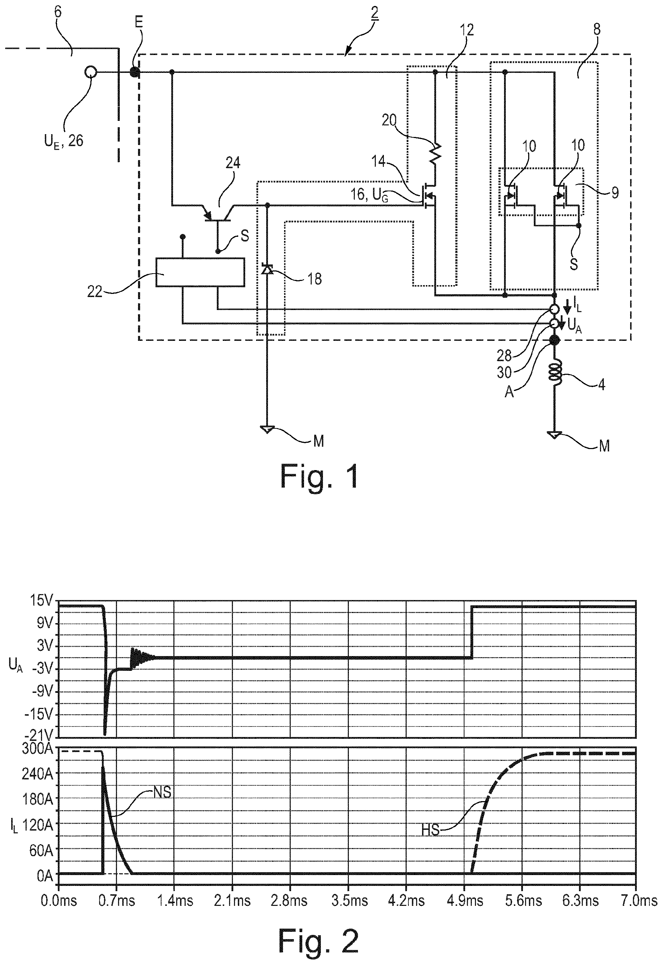

Die in Fig. 1 schematisch dargestellte Schaltvorrichtung 2 ist insbesondere für ein Kraftfahrzeugbordnetz ausgebildet und dient zum elektrischen Verbinden einer elektrischen Last 4 mit einer Energiequelle 6. Bei der elektrischen Last handelt es sich um ein oder mehrere Verbraucher, beispielsweise ein Elektromotor. Die elektrische Last 4 ist im Ausführungsbeispiel als eine induktive Last 4 und somit im Schaltbild gemäß Fig. 1 als Spule dargestellt. Die Energiequelle 6 ist in Fig. 1 lediglich angedeutet dargestellt. Bei der Energiequelle 6 handelt es sich beispielsweise um eine Batterie des nicht dargestellten Kraftfahrzeuges, um einen Spannungswandler oder um einen Kondensator, der im Kraftfahrzeug angeordnet ist. Die Schaltvorrichtung 2 weist einen Eingang E auf, der mit der Energiequelle 6 verbunden ist und einen Ausgang A, an dem die Last 4 angeschlossen ist. Im Betrieb liegt am Ausgang A und damit auch an der elektrischen Last 4 eine elektrische Last- oder Ausgangsspannung U_{A} an und es wird am Ausgang A ein Laststrom I_{L} bereitgestellt.

Weiterhin weist die Schaltvorrichtung 2 einen Hauptstrompfad 8 auf, der eine Schalteinheit 9 mit zumindest einem Leistungsschalter 10 und bevorzugt mehrere, parallel zueinander geschaltete Leistungsschalter 10 aufweist. Im Ausführungsbeispiel weist die Schaltvorrichtung 2 zwei Leistungsschalter 10 auf. Die Leistungsschalter 10 sind im Ausführungsbeispiel als Leistungs-MOSFET ausgebildet. Über die Leistungsschalter 10 ist die elektrische Last 4 in einem Versorgungs-Modus mit der Energiequelle 6 elektrisch verbunden. Unter dem Versorgungs-Modus wird hierbei ein Normalbetrieb der Schaltvorrichtung 2 verstanden, in dem die Leistungsschalter 10 vorzugsweise dauerhaft geschlossen, also leitend sind. Der Hauptstrompfad 8 und die Schalteinheit 9 sind für einen maximalen Gesamt-Betriebsstrom typischerweise im Bereich von größer 50 bis beispielsweise 500 A oder auch 1000A speziell bei kurzzeitigen Belastungen ausgebildet.

Weiterhin weist die Schaltvorrichtung 2 einen parallel zu dem Hauptstrompfad 8 verschalteten Nebenstrompfad 12 auf, in dem ein im Ausführungsbeispiel als ein Halbleiterschalter ausgebildetes erstes Schaltelement 14 angeordnet ist. Mittels des ersten Schaltelements 14 ist somit ebenfalls eine elektrisch leitende Verbindung zwischen der Energiequelle 6 und der elektrischen Last 4 realisierbar. Im Nebenstrompfad 12 ist weiterhin ein Leistungsverbraucher, insbesondere ein Widerstand 20 in Reihe zum ersten Schaltelement 14 angeordnet.

Das erste Schaltelement 14 weist einen Gate-Anschluss 16 mit einem Gate-Spannungspotential U_{G} auf. Der Gate-Anschluss 16 und somit das Gate-Spannungspotential U_{G} sind mit einem Massepotential M elektrisch verbunden. Ebenso weist der Nebenstrompfad 12 eine Diode 18 auf, die zwischen dem Gate-Anschluss 16 und dem Massepotential M angeordnet ist sowie in Sperrrichtung mit dem Massepotential M elektrisch verbunden ist.

Weiterhin ist ein zweites Schaltelement 24 als Teil der Schaltvorrichtung 2 vorgesehen, welches zum schaltbaren elektrischen Verbinden des Gate-Anschlusses 16 des ersten Schaltelements 14 mit der Energiequelle 6, insbesondere mit einem Phasenanschluss 26 ("Plus-Pol") der Energiequelle 6 dient.

Schließlich ist eine Steuereinheit 22 vorgesehen, über die unterschiedliche Funktionen der Schaltvorrichtung 2 angesteuert werden, wie nachfolgend noch erläutert wird. Speziell dient die Steuereinheit 22 auch zum Ansteuern der Leistungsschalter 10 und des zweiten Schaltelements 24. Hierzu ist die Steuereinheit in hier nicht näher dargestellter Weise jeweils mit einem Steueranschluss S des jeweiligen Schaltelements 10, 24 verbunden

### Abschalt-Modus:

Die elektrische Verbindung des Gate-Anschlusses 16 und somit des Gate-Spannungspotentials U_{G} mit dem Massepotential M dient einem automatischen Schließen des ersten Schaltelements 14 in einem Abschalt-Modus. Unter dem Abschalt-Modus wird hierbei ein Betriebsmodus der Schaltvorrichtung 2 verstanden, bei dem die Last 4 durch Trennen der Schalteinheit 9 abgeschalten wird, d.h. die Schalteinheit 9 wird geöffnet.

Innerhalb der Last 4 sowie ggf. innerhalb einer Versorgungsleitung zur Last 4 ist eine (Rest-) Energie gespeichert. Bei einer induktiven Last 4 resultiert aus dem Induktionsgesetz und dem Absinken des Laststroms sowie der in der Last 4 gespeicherten induktiven Energie eine negative Gegenspannung in Form eines negativen Spannungsimpulses.

Aufgrund der elektrischen Verbindung des Gate-Anschlusses 16 mit dem Massepotential M erfolgt durch den negativen Spannungsimpuls beim Abschalten ein Überschreiten einer Steuerspannung am Gate-Anschluss 16 des ersten Schaltelements 14 und somit ein automatisches Schließen des ersten Schaltelements 14.

Dadurch wird die elektrische Last 4 bei einem Abschalten der Last 4 automatisch über den Nebenstrompfad 12 mit der Energiequelle 6 elektrisch verbunden. Ein nach dem Abschalten noch fließender Strom infolge der gespeicherten Energie wird daher über den Nebenstrompfad 12 abgeleitet. Die gespeicherte elektrische (Rest-)Energie wird und im Wiederstand 20 in thermische Energie umgewandelt. Hierdurch sind die Leistungsschalter 10 der Schalteinheit 9 im Hauptstrompfad 8 geschützt.

Fällt die Gegenspannung wieder unter einem bestimmten Wert, so öffnet das erste Schaltelement 14 wieder automatisch, so dass die Last 4 vollständig von der Energiequelle 6 getrennt ist.

Der Abschalt-Modus dient daher der Reduzierung der innerhalb der elektrischen Last 4 gespeicherten elektrischen Energie bei einem Abschalten der Schalteinheit 9.

Der Spannungs- und Stromverlauf bei einem Abschalten, also während des Abschalt-Modus, ist beispielhaft anhand der Fig. 2 dargestellt:
Die obere Kurve zeigt den Verlauf der Ausgangsspannung U_{A} am Ausgang A und damit die an der Last 4 anliegende Lastspannung. Die untere Kurve zeigt den Verlauf des Laststroms I_{L}. Dabei zeigt die gestrichelt dargestellte Linie "HS" den Verlauf des Laststroms I_{L} über den Hauptstrompfad 8 und die durchgezogene, dicke Linie "NS" den Verlauf des Laststroms I_{L} über den Nebenstrompfad 12. Die angegebenen Werte für die Spannung und den Strom sind lediglich beispielhafte, aber realistische Werte.

Zu einem Zeitpunkt von ca. 0,5ms erfolgt das Trennen der Last 4 über die Schalteinheit 9, d.h. die Leistungsschalter 10 werden geöffnet. Dies führt zu einem negativen Spannungsimpuls (z.B. von + 15 V auf -ca.20V). Der Laststrom I_{L} fällt nach dem Abschalten von einen Nennstrom von z.B. mehreren 100 A (z.B. ca. 300A) kontinuierlich auf 0A innerhalb weniger Nano- oder Millisekunden ab. Durch den negativen Spannungsimpuls wird das erste Schaltelement 14 geschlossen und der Laststrom I_{L} fließt über den Nebenstrompfad 12 ab. Steigt die Last- oder Ausgangsspannung U_{A} wieder bis auf einen bestimmten Wert an, im Beispiel ca. -3V, so öffnet das erste Schaltelement 14 wieder und die Last 4 ist von der Energiequelle 6 getrennt.

Nach einem Zuschalten der Schalteinheit 9, im Beispiel bei ca. 5ms, steigt der Laststrom I_{L} sowie die Ausgangsspannung U_{A} wieder auf die Ausgangswerte an.

### Diagnose Modus:

Weiterhin ist ein Diagnose-Modus vorgesehen, in dem die Schalteinheit 9 ebenfalls geöffnet ist und die elektrische Last 4 lediglich über den Nebenstrompfad 12 mit der Energiequelle 6 verbunden ist. Während des Diagnose-Modus erfolgt eine Überprüfung speziell eines oder mehrerer der Leistungsschalters 10.

Hierzu ist eine Steuereinheit 22 vorgesehen, die im Ausführungsbeispiel gemäß Fig. 1 Teil der Schaltvorrichtung 2 ist. Die Steuereinheit 22 ist bevorzugt als ein Mikrocontroller ausgebildet oder weist einen solchen auf. Die Steuereinheit 22 ist nicht zwingend Bestandteil der Schaltvorrichtung. Beispielsweise ist sie als eine eigenständige Baueinheit ausgebildet oder in einer solchen angeordnet. Sie ist beispielsweise entfernt von der Schaltvorrichtung bzw. von den restlichen Teilen der Schaltvorrichtung 2 angeordnet. Beispielsweise handelt es sich um eine übergeordnete Steuereinrichtung. Die einzelnen Komponenten der Schaltvorrichtung 2 - mit oder ohne Steuereinheit 22 - sind vorzugsweise auf einer gemeinsamen Leiterplatte angeordnet.

Weiterhin ist die Steuereinheit 22 zum Aktivieren des Diagnose-Modus ausgebildet. Hierzu ist wird das zweite Schaltelement 24 von der Steuereinheit 22 geeignet angesteuert, so dass der Gate-Anschlusse 16 des ersten Schaltelements 14 mit der Energiequelle 6 verbunden wird.

Durch das elektrische Verbinden des Gate-Anschlusses 16 des ersten Schaltelements 14 mit dem Phasenanschluss 26 der Energiequelle 6 weist das Gate-Spannungspotential U_{G} im Diagnose-Modus den gleichen Wert auf, wie ein Spannungspotential U_{E} der Energiequelle. Das Spannungspotential U_{G} der Energiequelle 6 entspricht hierbei beispielsweise einer Betriebsspannung der Kraftfahrzeugbatterie.

Durch diese Maßnahme wird das erste Schaltelement 14 geschlossen, so dass die Last 4 mit der Energiequelle 6 über den Nebenstrompfad 12 verbunden ist. Die leistungslos geschalteten Leistungsschalter 10 können dann im Rahmen der vorgesehenen Diagnose überprüft werden.

Grundsätzlich ist darauf hinzuweisen, dass die Last (also der oder die Verbraucher) in mehreren unterschiedlichen Lastzuständen betrieben wird. Dies wird über eine hier nicht weiter dargestellte Steuervorrichtung gesteuert. Handelt es sich beispielsweise bei der Last / dem Verbraucher um einen elektrischen Motor, so wird dessen Last- und Stromaufnahme durch die Steuervorrichtung entsprechend den Anforderungen angesteuert.

Die Diagnose wird generell durchgeführt, ohne dass die Last 4 von der Energiequelle 6 getrennt ist. Dabei wird die Diagnose während lastarmen Betriebszuständen der Last 4 durchgeführt. Um ein sicheres Durchführen de Diagnose bei lastarmen Zuständen bei gleichzeitiger Versorgung der Last 4 zu gewährleisten sind spezielle Maßnahmen vorgesehen:
Zunächst ist die Steuereinheit 22 derart eingerichtet, die elektrische Ausgangsspannung U_{A} zu erfassen. Hierzu ist die Steuereinheit 22 im Ausführungsbeispiel mit einer Spannungserfassungseinheit 30 verbunden. Die Steuereinheit 22 ist zudem derart eingerichtet, in Abhängigkeit der erfassten Ausgangsspannung U_{A} zwischen dem Versorgungs-Modus und dem Diagnose-Modus zu unterscheiden. Dieser Ausgestaltung liegt der Gedanke zugrunde, dass die Ausgangsspannung U_{A}, im Diagnose-Modus um vorzugsweise 2V bis 4V geringer ist, als die Ausgangsspannung U_{A} im Versorgungs-Modus. Der Versorgungsmodus ist allgemein dadurch gekennzeichnet, dass die Schalteinheit 9 geschlossen ist, und dass ergänzend vorzugsweise das erste Schaltelement 14 offen ist.

Somit liegen für die Ausgangsspannung U_{A} sowohl für den Versorgungs-Modus als auch für den Diagnose-Modus charakteristische Spannungswerte vor, anhand derer die Steuereinheit 22 die beiden Modi (Versorgungs-Modus und Diagnose-Modus), also speziell die Schaltzustände der Schalteinheit 9 und des ersten Schaltelements 14 voneinander unterscheiden kann.

Weiterhin ist die Steuereinheit 22 zur Ermittlung des aktuellen Laststroms I_{L} ausgebildet und hierzu beispielsweise mit einem Strommesselement 28 der Schaltvorrichtung 2 verbunden. Alternativ erhält die Steuereinheit 22 die Information über den aktuellen Laststrom I_{L} auch anderweitig, z.B. von einer Steuervorrichtung, z.B. einer Motorsteuerung eines als Last verwendeten Motors. In der bevorzugten Ausführungsvariante ist dies jedoch nicht vorgesehen.

Das Strommesselement 28 dient im Ausführungsbeispiel zum direkten Messen des Laststroms I_{L}, der durch die elektrische Last 4 fließt. Weiterhin ist die Steuereinheit 22 derart eingerichtet, in Abhängigkeit eines Wertes des erfassten Laststromes I_{L} durch eine Ansteuerung des ersten Schaltelements 14 und des zumindest einen Leistungsschalters 10 zwischen dem Versorgungs-Modus und dem Diagnose-Modus umzuschalten. Wird also anhand des Laststroms I_{L} ein lastarmer Zustand erkannt, so wird der Nebenstrompfad 12 durch gesteuertes Schließen des ersten Schaltelements 14 (mittels des zweiten Schaltelements 24) aktiviert.

Bevorzugt ist die Steuereinheit 22 auch zum Ansteuern der Leistungsschalter 10 ausgebildet, um diese zu öffnen. Dadurch wird insgesamt vom Versorgungs-Modus, in dem die Schalteinheit 9 geschlossen ist und das erste Schaltelement 14 geöffnet ist, in den Diagnose-Modus umgeschaltet. Hierzu übermittelt die Steuereinheit 22 die erwähnten Steuer- oder Schaltsignale an den jeweiligen Steueranschluss, die ein Öffnen der Leistungsschalter 10 und ein Schließen des ersten Schaltelements 14 bewirken. Hierbei erfolgt das Schließen des ersten Schaltelements 14 bevorzugt zeitlich (kurz, weniger als 1 ms) vor dem Öffnen des zumindest einen Leistungsschalters 10, sodass über eine kurze Zeitspanne die elektrische Last 4 sowohl über den Hauptstrompfad 8 als auch über den Nebenstrompfad 12 mit der Energiequelle 6 elektrisch verbunden ist. Durch die elektrische Versorgung der elektrischen Last 4 über den Nebenstrompfad 12 ist somit eine unterbrechungsfreie elektrische Versorgung der elektrischen Last, insbesondere im Diagnose-Modus erreicht.

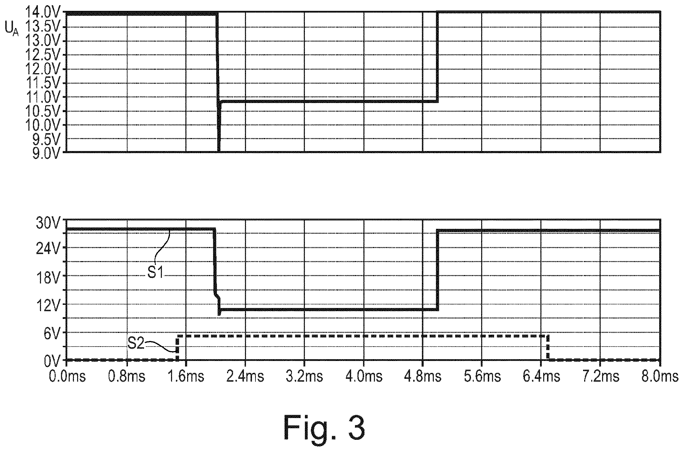

Das Umschalten zwischen dem Versorgungsmodus und dem Diagnose-Modus ist anhand der FIG 3 illustriert:
Die obere Kurve zeigt den Verlauf der Ausgangsspannung U_{A}, anhand derer zwischen den beiden Modi unterschieden werden kann. Das untere Teilbild zeigt zwei Kurven, wobei die obere Kurve den Verlauf eines ersten Schaltsignals S1 zum Schalten der Schalteinheit 9 und die untere Kurve den Verlauf eines zweiten Schaltsignals S2 zum Schalten des zweiten Schaltelements 24 zeigt.

Wie gut zu erkennen ist, liegt zunächst im Versorgungsmodus das Schaltsignal S1 auf einem hohen Niveau, so dass die Leistungsschalter derart angesteuert sind, dass sie und damit der Hauptpfad 8 geschlossen sind. Dann wird ergänzend das Schaltsignal S2 an das zweite Schaltelement 24 angelegt, so dass auch der Nebenstrompfad 12 geschlossen ist und eine Versorgung über beide Pfade 8,12 kurzfristig erfolgt. Anschließend wird die Steuerspannung des ersten Schaltsignals zumindest soweit reduziert, dass die Leistungsschalter 10 geöffnet werden. Dies macht sich an der Ausgangsspannung durch einen charakteristischen Spannungsabfall um ca. 3V bemerkbar. Es liegt aber weiterhin eine ausreichende Ausgangsspannung U_{A} an, so dass die Last 4 weiterhin versorgt ist.

In diesem Diagnose Modus wird die Diagnose durchgeführt, bevor anschließend wieder in den Versorgungsmodus umgeschaltet wird (Erhöhen der Steuerspannung für S1 und abschalten des Steuerspannung für S2)

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

### Bezugszeichenliste

- 2: Schaltvorrichtung
- 4: elektrische Last
- 6: Energiequelle
- 8: Hauptstrompfad
- 9: Schalteinheit
- 10: Leistungsschalter
- 12: Nebenstrompfad
- 14: erstes Schaltelement
- 16: Gate-Anschluss
- 18: Diode
- 20: Widerstandselement
- 22: Steuereinheit
- 24: zweites Schaltelement
- 26: Phasenanschluss
- 28: Strommesselement
- 30: Spannungserfassungseinheit

- U_{A}: Ausgangsspannung
- U_{E}: Versorgungsspannung der Energiequelle
- U_{G}: Gate-Spannungspotential
- I_{L}: Laststrom
- M: Massepotential
- E: Eingang
- A: Ausgang
- S: Steueranschluss
- S1: Schaltsignal
- S2: Schaltsignal

## Patentansprüche

1. Schaltvorrichtung (2), insbesondere für ein Kraftfahrzeugbordnetz zum elektrischen Verbinden einer elektrischen Last (4) mit einer Energiequelle (6), die aufweist:
- einen Hauptstrompfad (8), der eine Schalteinheit (9) mit zumindest einem Leistungsschalter (10) aufweist, über den die elektrische Last (4) in einem Versorgungs-Modus mit der Energiequelle (6) verbunden ist,
- einen parallel zu dem Hauptstrompfad (8) verschalteten Nebenstrompfad (12), in dem ein erstes Schaltelement (14) angeordnet ist,
wobei die Schaltvorrichtung (2) dazu eingerichtet ist,
- in einem Abschalt-Modus zum Abschalten der Last (4) die Schalteinheit (9) zu öffnen und die elektrische Last (4) über den Nebenstrompfad (12) mit der Energiequelle zur Reduzierung einer innerhalb der elektrischen Last (4) gespeicherten elektrischen Energie zu verbinden, **dadurch gekennzeichnet, dass**
- die Schaltvorrichtung (2) dazu eingerichtet ist, in einem Diagnose-Modus den zumindest eine Leistungsschalter (10) zu öffnen und die elektrische Last (4) lediglich über den Nebenstrompfad (12) mit der Energiequelle (6) zu verbinden, wobei eine unterbrechungsfreie elektrische Versorgung der elektrischen Last (4) bei geöffneter Schalteinheit (9) sichergestellt ist,
- wobei der Diagnose-Modus über eine Steuereinheit (22) aktivierbar ist und im Diagnose-Modus eine Diagnose der Schaltvorrichtung erfolgt.

2. Schaltvorrichtung (2) nach dem vorhergehenden Anspruch,
wobei das erste Schaltelement (14) derart ausgebildet ist, dass es beim Abschalten der Last (4) automatisch aufgrund der beim Abschalten auftretenden Spanungsimpulse geschlossen wird.

3. Schaltvorrichtung (2) nach dem vorhergehenden Anspruch,
wobei das erste Schaltelement (14) als ein Halbleiterschalter ausgebildet ist und einen Gate-Anschluss (16) mit einem Gate-Spannungspotential (U_{G}) aufweist, das mit einem Masse-Potential (M) elektrisch verbunden ist.

4. Schaltvorrichtung (2) nach dem vorhergehenden Anspruch,
wobei der Nebenstrompfad (12) eine Diode (18) aufweist, die zwischen dem Gate-Anschluss (16) des ersten Schaltelements (14) und dem Masse-Potential (M) angeordnet ist und in Sperrrichtung mit dem Masse-Potential (M) elektrisch verbunden ist.

5. Schaltvorrichtung (2) nach einem der vorhergehenden Ansprüche,
wobei in dem Nebenstrompfad (12) ein Leistungsverbraucher, insbesondere ein Widerstandselement (20) angeordnet ist, zur Umwandlung von in der elektrischen Last (4) gespeicherter elektrischer Energie.

6. Schaltvorrichtung (2) nach einem der vorhergehenden Ansprüche und Anspruch 3,
wobei das Gate-Spannungspotential (U_{G}) im Diagnose-Modus den gleichen Wert aufweist, wie ein Spannungspotential (U_{E}) der Energiequelle.

7. Schaltvorrichtung (2) nach einem der vorhergehenden Ansprüche und Anspruch 3,
wobei ein zweites Schaltelement (24) vorgesehen ist, zum elektrischen Verbinden des Gate-Anschlusses (16) des ersten Schaltelements (14) mit der Energiequelle (6) im Diagnose-Modus.

8. Schaltvorrichtung (2) nach einem der vorhergehenden Ansprüche,
wobei die Steuereinheit (22) derart eingerichtet ist, eine elektrische Ausgangspannung (U_{A}), die an der elektrischen Last (4) anliegt zu erfassen.

9. Schaltvorrichtung (2) nach dem vorhergehenden Anspruch,
wobei die Steuereinheit (22) derart eingerichtet ist, in Abhängigkeit der Ausgangsspannung (U_{A}) die Durchführung der Diagnose zu starten.

10. Schaltvorrichtung (2) nach einem der vorhergehenden Ansprüche,
wobei die Steuereinheit (22) derart eingerichtet ist, im Diagnose-Modus den zumindest einen Leistungsschalter (10) zu überprüfen.

11. Schaltvorrichtung (2) nach einem der vorhergehenden Ansprüche,
die ein Strommesselement (28) zur Erfassung eines Laststroms (I_{L}) der elektrischen Last (4) aufweist, und die Steuereinheit (22) derart eingerichtet ist, in Abhängigkeit eines Wertes des erfassten Laststromes (I_{L}) zwischen dem Versorgungs-Modus und dem Diagnose-Modus umzuschalten.

12. Schaltvorrichtung (2) nach einem der vorhergehenden Ansprüche,
wobei der Nebenstrompfad (12) für einen geringeren Strom als der Hauptstrompfad (8) ausgelegt ist.

13. Verfahren zum Betrieb einer Schaltvorrichtung (2) zum elektrischen Verbinden einer elektrischen Last (4) mit einer Energiequelle (6), wobei
- über einen Hauptstrompfad (8), der eine Schalteinheit (9) mit zumindest einem Leistungsschalter (10) aufweist, die elektrische Last (4) in einem Versorgungs-Modus mit der Energiequelle (6) verbunden wird, indem die Schalteinheit (9) geschlossen wird,
- in einem Abschalt-Modus die Last (4) abgeschaltet wird und die Schalteinheit (9) hierzu geöffnet wird und die elektrische Last (4) über den Nebenstrompfad (12) mit der Energiequelle (6) zur Reduzierung einer innerhalb der elektrischen Last (4) gespeicherte elektrische Energie verbunden wird, indem das erste Schaltelement (14) geschlossen wird, **dadurch gekennzeichnet, dass**
- in einem Diagnose-Modus die Schalteinheit (9) geöffnet wird und das erste Schaltelement (14) geschlossen wird, sodass die elektrische Last (4) lediglich über den Nebenstrompfad (12) mit der Energiequelle (6) verbunden wird, wobei im Diagnose-Modus der zumindest eine Leistungsschalter (10) überprüft wird und gleichzeitig eine unterbrechungsfreie elektrische Energieversorgung der elektrischen Last (4) über den Nebenstrompfad (12) sichergestellt wird.

14. Verfahren nach dem vorhergehenden Anspruch,
bei dem
- das erste Schaltelement (14) als ein Halbleiterschalter ausgebildet ist, der im Abschalt-Modus durch ein von der elektrischen Last (4) nach einem Abschalten herrührenden Spannungsimpuls automatisch geschlossen wird und
- im Diagnose-Modus das erste Schaltelement (14) durch ein zweites Schaltelement (24) aktiv geschlossen wird.

## Claims

1. A switching device (2), in particular for a motor vehicle electrical system, for electrically connecting an electrical load (4) to an energy source (6), which has:
- a main current path (8) which has a switching unit (9) with at least one circuit breaker (10), via which the electrical load (4) is connected to the energy source (6) in a supply mode,
- a secondary current pass (12) connected in parallel with the main current path (8), in which a first switching element (14) is arranged,
wherein the switching device (2) is arranged to
- open the switching unit (9) in a switch-off mode for switching off the load (4) and to connect the electrical load (4) via the secondary current path (12) to the power source for reduction of electrical energy stored within the electrical load (4), **characterised in that**
- the switching device (2) is arranged, in a diagnostic mode, to open the at least one circuit breaker (10) and to connect the electrical load (4) to the energy source (6) only via the secondary current path (12), wherein an uninterrupted electrical supply to the electrical load (4) is ensured when the switching unit (9) is open,
- wherein the diagnostic mode can be activated via a control unit (22) and a diagnosis of the switching device is carried out in the diagnostic mode.

2. The witching device (2) according to the preceding claim,
wherein the first switching element (14) is formed in such a way that it is automatically closed when the load (4) is switched off on the basis of the voltage pulses occurring during switching off.

3. The switching device (2) according to the preceding claim,
wherein the first switching element (14) is formed as a semiconductor switch and has a gate terminal (16) with a gate voltage potential (U_{G}) which is electrically connected to a ground potential (M).

4. The switching device (2) according to the preceding claim,
wherein the secondary current path (12) has a diode (18) which is arranged between the gate terminal (16) of the first switching element (14) and the ground potential (M) and is electrically connected in the reverse direction to the ground potential (M).

5. The switching device (2) according to any one of the preceding claims,
wherein a power consumer, in particular a resistor element (20), is arranged in the secondary current path (12) for conversion of electrical energy stored in the electrical load (4).

6. The switching device (2) according to any one of the preceding claims and claim 3,
wherein the gate voltage potential (U_{G}) in diagnostic mode has the same value as a voltage potential (U_{E}) of the energy source.

7. The switching device (2) according to any one of the preceding claims and claim 3,
wherein a second switching element (24) is provided for electrically connecting the gate terminal (16) of the first switching element (14) with the power source (6) in the diagnostic mode.

8. The switching device (2) according to any one of the preceding claims,
wherein the control unit (22) is arranged in such a way as to detect an electrical output voltage (U_{A}) applied to the electrical load (4).

9. The switching device (2) according to the preceding claim,
wherein the control unit (22) is arranged in such a way as to start the performance of the diagnosis depending on the output voltage (U_{A}).

10. The switching device (2) according to any one of the preceding claims,
wherein the control unit (22) is arranged in such a way as to check the at least one circuit breaker (10) in the diagnostic mode.

11. The switching device (2) according to any one of the preceding claims,
which has a current measuring element (28) for detecting a load current (I_{L}) of the electrical load (4), and the control unit (22) is arranged in such a way as to switch between the supply mode and the diagnostic mode as a function of a value of the detected load current (I_{L}).

12. The switching device (2) according to any one of the preceding claims,
wherein the secondary current path (12) is designed for a lower current than the main current path (8).

13. A method for operation of a switching device (2) for electrically connecting an electrical load (4) to an energy source (6), wherein
- via a main current path (8), which has a switching unit (9) with at least one circuit breaker (10), the electrical load (4) is connected to the energy source (6) in a supply mode by closing the switching unit (9),
- in a switch-off mode, the load (4) is switched off and the switching unit (9) is opened for this purpose, and the electrical load (4) is connected to the energy source (6) via the secondary current path (12) for reduction of electrical energy stored in the electrical load (4) by closing the first switching element (14),
**characterized in that**,
- in a diagnostic mode, the switching unit (9) is opened and the first switching element (14) is closed, so that the electrical load (4) is connected to the energy source (6) only via the secondary current path (12), wherein in the diagnostic mode the at least one circuit breaker (10) is checked and at the same time an interruption-free electrical energy supply to the electrical load (4) is ensured via the secondary current path (12).

14. The method according to the preceding claim,
in which
- the first switching element (14) is formed as a semiconductor switch which, in the switch-off mode, is automatically closed by a voltage pulse originating from the electrical load (4) after a switch-off, and
- in the diagnostic mode the first switching element (14) is actively closed by a second switching element (24).

## Revendications

1. Dispositif de commutation (2), notamment pour un réseau de bord de véhicule automobile, destiné à la connexion électrique d'une charge électrique (4) à une source d'énergie (6), qui comporte :
- un circuit de courant principal (8) qui comporte une unité de commutation (9) comportant au moins un interrupteur de puissance (10) via lequel la charge électrique (4) est raccordée dans un mode d'alimentation à la source d'énergie (6),
- un circuit de courant secondaire (12) connecté en parallèle au circuit de courant principal (8), dans lequel est disposé un premier élément de commutation (14),
le dispositif de commutation (2) étant conçu pour
- dans un mode coupure de circuit destiné à la mise hors circuit de la charge électrique (4), ouvrir l'unité de commutation (9) et connecter la charge électrique (4) via le circuit de courant secondaire (12) à la source d'énergie pour la réduction d'une énergie électrique accumulée à l'intérieur de la charge électrique (4), **caractérisé en ce que**
- le dispositif de commutation (2) est conçu pour, dans un mode diagnostic, ouvrir ledit au moins un interrupteur de puissance (10) et ne connecter la charge électrique (4) à la source d'énergie (6) que via le circuit de courant secondaire (12), une alimentation électrique ininterrompue de la charge électrique (4) étant assurée lorsque l'unité de commutation (9) est ouverte,
- le mode diagnostic étant activable par une unité de commande (22) et un diagnostic du dispositif de commutation s'effectuant dans le mode diagnostic.

2. Dispositif de commutation (2) selon la revendication précédente,
dans lequel le premier élément de commutation (14) est configuré de telle façon que lors de la mise hors circuit de la charge (4) il est automatiquement fermé en raison des impulsions de tension apparaissant lors de la coupure.

3. Dispositif de commutation (2) selon la revendication précédente,
dans lequel le premier élément de commutation (14) est configuré sous forme d'un commutateur semi-conducteur et comporte une borne (16) de grille à une potentiel de tension (U_{G}) de grille qui est relié électriquement à un potentiel de masse (M).

4. Dispositif de commutation (2) selon la revendication précédente,
dans lequel le circuit de courant secondaire (12) comporte une diode (18) qui est disposée entre la borne (16) de grille du premier élément de commutation (14) et le potentiel de masse (M) et est raccordée électriquement en sens inverse au potentiel de masse (M).

5. Dispositif de commutation (2) selon l'une des revendications précédentes, dans lequel est disposé dans le circuit de courant secondaire (12) un consommateur de puissance, en particulier un élément de résistance (20), destiné à la conversion d'énergie électrique accumulée dans la charge électrique (4).

6. Dispositif de commutation (2) selon l'une des revendications précédentes et la revendication 3,
dans lequel le potentiel de tension (U_{G}) de grille dans le mode diagnostic présente la même valeur qu'un potentiel de tension (U_{E}) de la source d'énergie

7. Dispositif de commutation (2) selon l'une des revendications précédentes et la revendication 3,
dans lequel est prévu un deuxième élément de commutation (24), destiné à la connexion électrique de la borne (16) de grille du premier élément de commutation (14) à la source d'énergie (6) dans le mode diagnostic.

8. Dispositif de commutation (2) selon l'une des revendications précédentes,
dans lequel l'unité de commande (22) est conçue de manière à détecter une tension de sortie électrique (U_{A}) qui est appliquée sur la charge électrique (4).

9. Dispositif de commutation (2) selon la revendication précédente,
dans lequel l'unité de commande (22) est conçue de manière à déclencher l'exécution du diagnostic en fonction de la tension de sortie (U_{A}).

10. Dispositif de commutation (2) selon l'une des revendications précédentes,
dans lequel l'unité de commande (22) est conçue de manière à contrôler dans le mode diagnostic ledit au moins un interrupteur de puissance (10).

11. Dispositif de commutation (2) selon l'une des revendications précédentes,
qui comporte un élément de mesure (28) du courant, destiné à la détection d'un courant de charge (I_{L}) de la charge électrique (4), et l'unité de commande (22) est conçue de manière à commuter entre le mode alimentation et le mode diagnostic en fonction d'une valeur du courant de charge (I_{L}) détecté.

12. Dispositif de commutation (2) selon l'une des revendications précédentes, dans lequel le circuit de courant secondaire (12) est conçu pour un courant plus faible que le circuit de courant principal (8).

13. Procédé pour le fonctionnement d'un dispositif de commutation (2) destiné à la connexion électrique d'une charge électrique (4) à une source d'énergie (6), dans lequel
- via un circuit de courant principal (8) qui comporte une unité de commutation (9) comportant au moins un interrupteur de puissance (10) la charge électrique (4) est raccordée dans un mode alimentation à la source d'énergie (6), par le fait que l'unité de commutation (9) est fermée,
- dans un mode coupure de circuit la charge électrique (4) est mise hors circuit et l'unité de commutation (9) est à cette fin ouverte et la charge électrique (4) est connectée via le circuit de courant secondaire (12) à la source d'énergie (6) pour la réduction d'une énergie électrique accumulée à l'intérieur de la charge électrique (4), par le fait que le premier élément de commutation (14) est fermé,
**caractérisé en ce que**
- dans un mode diagnostic, l'unité de commutation (9) est ouverte et le premier élément de commutation (14) est fermé, de sorte que la charge électrique (4) n'est connectée à la source d'énergie (6) que via le circuit de courant secondaire (12), dans le mode diagnostic ledit au moins un interrupteur de puissance (10) étant contrôlé et en même temps une alimentation en énergie électrique ininterrompue de la charge électrique (4) étant assurée via le circuit de courant secondaire (12)

14. Procédé selon la revendication précédente,
dans lequel
- le premier élément de commutation (14) est configuré sous forme d'un commutateur semi-conducteur qui dans le mode coupure de circuit est automatiquement fermé par une impulsion de tension provoquée par la charge électrique (4) après une coupure de circuit et
- dans le mode diagnostic le premier élément de commutation (14) est activement fermé par un deuxième élément de commutation (24).
